(19) Europäisches Patentamt
European Patent Office
Office européen des brevets

(11) EP 1 758 372 A1

(12) EUROPEAN PATENT APPLICATION

(43) Date of publication:
28.02.2007 Bulletin 2007/09

(51) Int Cl.:
H04N 5/217 (2006.01)   H04N 5/335 (2006.01)
H01L 27/146 (2006.01)

(21) Application number: 06254309.5

(22) Date of filing: 17.08.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 23.08.2005 US 209446

(71) Applicant: OmniVision Technologies, Inc.
Sunnyvale,
California 94089 (US)

(72) Inventors:
• Nagaraja, Satyadev H.
San Jose, California 95128 (US)
• Rhodes, Howard E.
Boise, Idaho 83706 (US)

(74) Representative: Webster, Jeremy Mark et al
Mewburn Ellis LLP
York House
23 Kingsway
London
WC2B 6HP (GB)

(54) Method and apparatus for reducing optical crosstalk in cmos image sensors

(57)   An image sensor in which the metal interconnects are coated with an anti-reflective coating is disclosed The top, bottom and sides of the metal interconnects may be coated to reduce reflection from all directions. The thickness of the coating is chosen to suppress reflection of light of certain wavelengths incident at certain expected angles. In particular, the thickness of the coating may be chosen to reduce reflections from neighboring pixels. The metal may be coated in multiple layers of anti-reflective coating to suppress multiple wavelengths of light or multiple angles of incidence.

FIGURE 2

EP 1 758 372 A1

**Description**

Image sensors have become ubiquitous. They are widely used in digital still cameras, cellular phones, security cameras, medical, automobile, and other applications. The technology used to manufacture image sensors, and in particular CMOS image sensors, has continued to advance at great pace. For example, the demands of higher resolution and lower power consumption have encouraged the further miniaturization and integration of the image sensor.

Typically each pixel of an image sensor includes a photosensitive element, such as a photodiode, and one or more transistors for reading out the signal from the photosensitive element. CMOS image sensors use metal wires to connect the individual pixels to each other and to the output. These metal wires (also referred to as metal interconnects) are often at different layers in the silicon in order to make contact with different parts of the transistors and for efficient routing.

A significant problem for these image sensors is optical crosstalk. Optical crosstalk occurs when light that should have hit one pixel instead hits another, usually neighboring, pixel. This causes artifacts in the image and can not be corrected with image processing. A common cause of optical crosstalk is light reflecting off of the silicon and/or reflecting off of a metal wire and then striking a remote pixel.

BRIEF DESCRIPTION OF THE DRAWINGS

Figure 1 is a cross-sectional view of a prior art image sensor illustrating the optical crosstalk issue.

Figure 2 is a cross-sectional view of an image sensor showing a first embodiment of the present invention.

Figure 3 is a close-up view of light incident on an anti-reflective coating.

Figure 4 is a cross-sectional view of an image sensor showing a particular type of optical crosstalk.

Figure 5 shows an alternate embodiment of the invention that uses multiple layers of anti-reflective coating.

Figures 6-25 are cross-sectional views showing various embodiments of how the anti-reflective layer can be formed.

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

References throughout the specification to "one embodiment" or "an embodiment" means that a particular feature, structure, or characteristic described in connection with the embodiment is included in at least one embodiment of the present invention. Thus, the appearances of the phrase "in one embodiment," or "in an embodiment" in various places throughout the specification are not necessarily all referring to the same embodiment. Furthermore, the particular features, structures, or characteristics may be combined in any suitable manner in one or more embodiments.

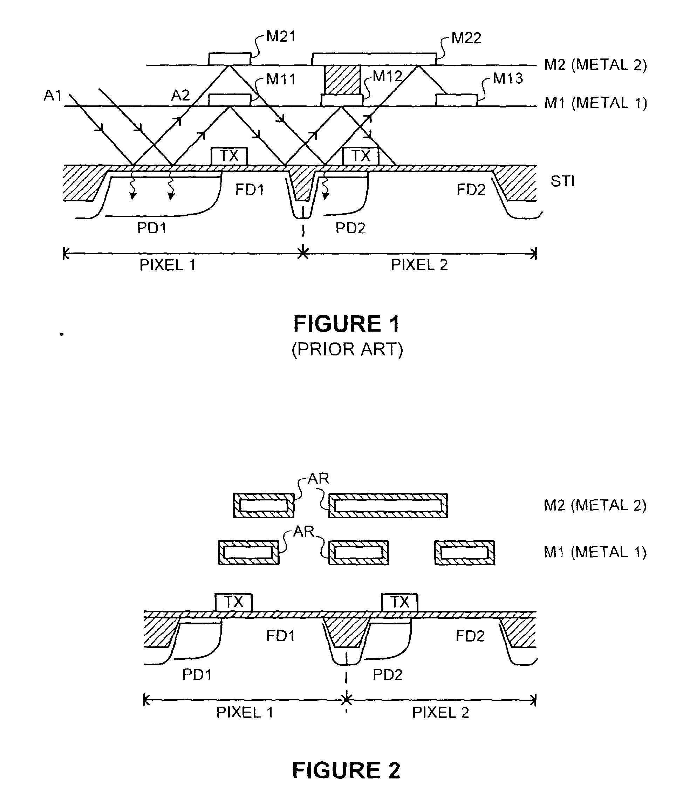

Turning to Figure 1, a cross-section of a prior art image sensor is shown. In the view shown in Figure 1, two adjacent pixels are shown. Note that the precise internal structure of the pixel is not particularly germane to the present invention, and indeed, the present invention may be utilized with any CMOS pixel design, including but not limited to 3T, 4T, 5T, 6T, 7T, or other pixel designs.

As shown in Figure 1, the image sensor may have metal interconnects at different layers of the integrated circuit to connect different parts of the sensor. The exact layer or location of the metal interconnects may vary, depending on the particular design of the sensor.

As shown in Figure 1, incident light, A, strikes a photodiode, PD1. Some of the light is absorbed by the photodiode, as designed. However, some of the light, $A_2$, reflects off of the surface of the photodiode and strikes a metal interconnect, such as M21. That light may then be collected at a neighboring photodiode, PD2. It is also possible for light to reflect off of the bottom of a metal interconnect such as M22, and strike the top of a metal interconnect at a lower layer, M13. The light could then continue to reflect until striking a pixel even farther away.

In order to address this issue, the present invention coats the metal interconnects with an anti-reflective (AR) coating to reduce reflection from the metal interconnect. The AR coating may be any one of a number of materials well-known in the art. Coatings used may be insulating, such as tin oxide, indium tin oxide or indium oxide or they may be conductive, such as silicon nitride.

Turning to Figure 2, a cross-sectional view of an image sensor with an AR coating on the metal interconnects is shown. As in Figure 1, the particular internal structure of the pixels is not germane. In one embodiment, the AR coating is put on the bottom of the metal interconnects to reduce reflection of light incident from below the metal interconnects. In another embodiment, the AR coating is put on all sides of the metal interconnects to reduce reflection from all directions. Light incident on the metal interconnects that strikes the AR coating either does not reflect or reflects with its intensity greatly attenuated.

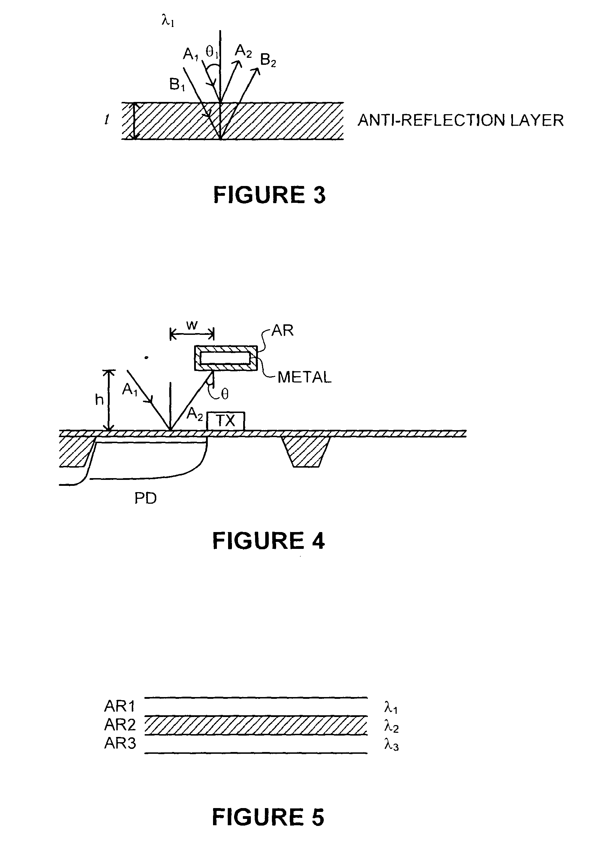

The AR coating reduces reflection in two ways. First, it may absorb part of the incident light. Second, it may cause destructive interference between different reflections off of the coating. Turning to Figure 3, a close-up of light incident on the anti-reflective coating is shown. Figure 3 shows how the AR coating causes destructive interference. Light with a wavelength of $\lambda_1$ is incident at an angle $\Theta_1$. A portion of incident light $A_1$ reflects when

it hits the outer surface of the AR coating. Another part of the incident light, $B_1$, reflects when it hits the inner surface. The intensity of the reflected light will be most attenuated when the reflected light $A_2$ has a phase difference of 180° from the reflected light $B_2$.

The convention for choosing the thickness of AR layers is to assume that the light is incident normally on the AR coating. In that case, the intensity of the reflected light will be most reduced when the thickness of the material, t, is equal to $\lambda/4$.

However, in the case of optical crosstalk, all light will be incident at some angle to the normal. In that case, the reduction in the light's intensity varies based on the incident angle $\ominus$ and the wavelength of the incident light. The thickness of the coating can be chosen to suppress light of a certain wavelength, $\lambda_1$, and angle of incidence, $\ominus_1$. At angles of incidence close to, but not equal to, $\ominus_1$, the reflected light intensity will be strongly attenuated, but not eliminated. Similarly, for light of wavelength $\lambda_2$ close to, but not equal to, $\lambda_1$, reflection will be strongly attenuated, but not eliminated.

Turning to Figure 4, a particular example of optical crosstalk is shown. A significant contribution to optical crosstalk is from light that should have been collected at the adjacent pixel. In one embodiment of this invention, the thickness of the AR coating may be chosen to minimize reflection of light from the adjacent pixel. The expected incident angle at a particular point, P, on the metal interconnect may be calculated based on the horizontal distance between P and the center of PD, w, and on the height of the metal interconnect above PD, h. In that case, the expected angle of incidence $\ominus$ at P would

be equal to $\tan^{-1} \dfrac{w}{h}$. In this embodiment, the thickness at P would be chosen based on $\ominus$, the expected wavelength of the incident light and the refractive index of the AR coating, n. The thickness would be analytically given by the formula $t = \dfrac{\lambda}{4n} \cos \ominus$. In practical situations,

however, the thickness may be determined from computer simulations, which may take into account such additional factors as properties of the metal interconnect, diffusion barriers cladding the metal interconnects and the interlayer and inter-metal dielectrics.

For example, assume that the image sensor is designed to have a layer of metal interconnects 0.58 microns above the surface of the sensor and a horizontal distance between the center of PD and the metal interconnect of 1 micron. Assume also that the AR coating is being chosen to block incident light with a wavelength of 650 nm. In that case, the expected angle of incidence of the light striking the metal interconnect would be 60°. Assuming a refractive index of 2, the required thickness of the AR coating would be 40.625 nm.

Turning to Figure 5, an alternate embodiment with multiple AR layers is shown. Any number of AR layers can be incorporated successively into a stack in order to suppress reflection of multiple wavelengths or angles of incidence. The thicknesses of the layers can then be calculated according to the same method as discussed above for the single layer.

In one embodiment, the image sensor uses a color coding scheme based on red, blue and green. In this embodiment, the metal interconnects may be coated with three different AR layers designed for each of the different colors in the coding scheme. The thickness may then be chosen based on the three wavelengths and on the expected angle of incidence, which may be chosen in any way.

Those skilled in the art will appreciate that embodiments of this invention can be formed in many ways. The process of forming the embodiments may depend on the type of metal used in the metal interconnects, among other factors. For example, if the metal interconnects are to be made of aluminum, the manufacture process will be more likely to use subtractive methods, while additive methods will be more likely in the case of copper interconnects. Several possible methods will be described below.

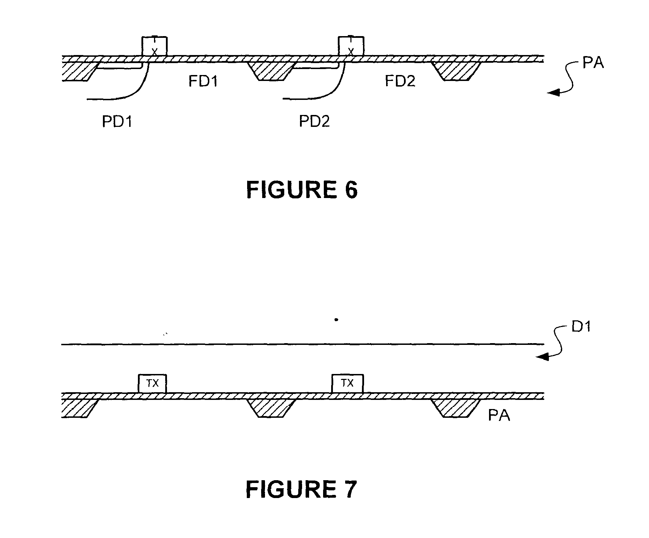

Figures 6-25 illustrate several methods of forming the embodiment of Figure 2. Specifically, turning to Figure 6, two pixels from a pixel array after the end of the front-end-of-line (FEOL) process is shown. At this point in the process, no features have been formed above the level of the pixels. As noted above, the internal structure of the pixels is not germane to the process. The present method may be used with any method of implementing the FEOL process.

Turning to Figure 7, a pixel array with a first layer of dielectric is shown. Following the end of the FEOL process, the back-end-of-line process (BEOL) is begun as a first layer of dielectric D1 is deposited over the pixels. The particular type of dielectric used for this layer is not germane to this invention, as any material known to the art could be used, such as a planar oxide.

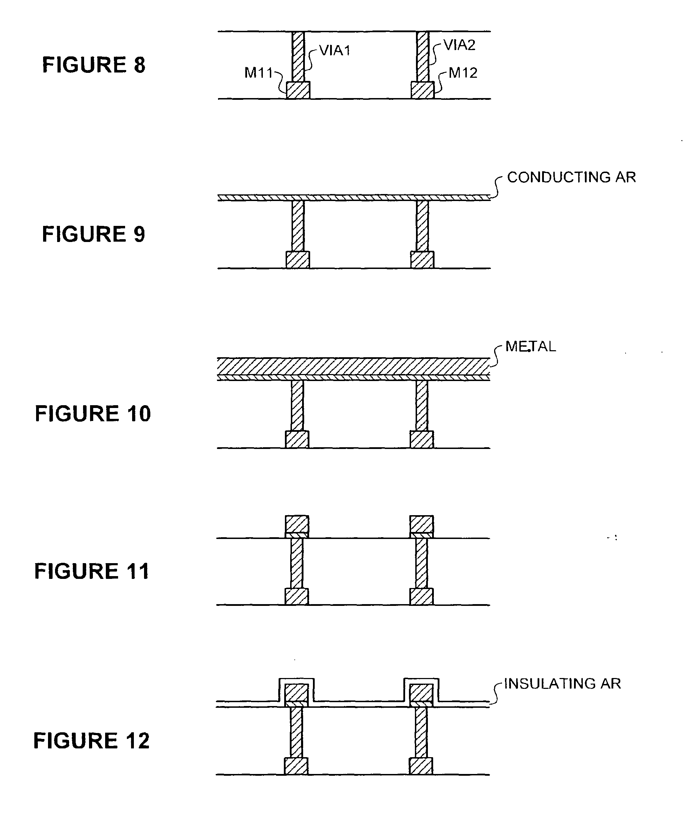

Turning to Figure 8, a pixel array with vias to connect layers of metal interconnects is shown. After a layer of dielectric has been deposited, vias to connect different layers of metal interconnects may be made through any process known to the art. In Figure 8, a via has been formed to connect a metal interconnect at a higher level to the metal interconnect M11. The higher level metal interconnect has not yet been formed. As with the pixel structure, the method chosen to make the vias is not germane to the invention. An important consideration in forming embodiments is that the connection between the via and the interconnect must be maintained. The appropriate process to use will vary depending on whether an insulating coating or a conductive coating is used.

As noted above, a subtractive process is generally used to form metal interconnects using aluminum. Embodiments that use subtractive processes will be discussed below.

In one embodiment, a conductive AR coating is used for the bottom layer. Turning to Figure 9, a pixel array with a layer of conductive AR coating is shown. After the dielectric layer is deposited, a layer of conductive AR coating is deposited using any conventional method. Those skilled in the art will appreciate that this could be done using any number of deposition methods known in the art, including sputtering and chemical vapor deposition (CVD).

Turning to Figure 10, a pixel array with layers of metal and AR coating is shown. After the layer of conductive AR coating is deposited, a layer of metal is deposited using any conventional method. As above, those skilled in the art will appreciate that this could be done using any number of deposition methods known in the art.

Turning to Figure 11, a pixel array with the metal interconnects formed is shown. After the layer of metal is deposited, the metal and AR coating layers are removed to form the desired pattern of metal interconnects using any method known to the art. For example, those skilled in the art will appreciate that this could be done through any number of methods, including a masking and etching step. The conductive AR coating is removed in the same step as the metal, so the AR coating remains only under the metal interconnect.

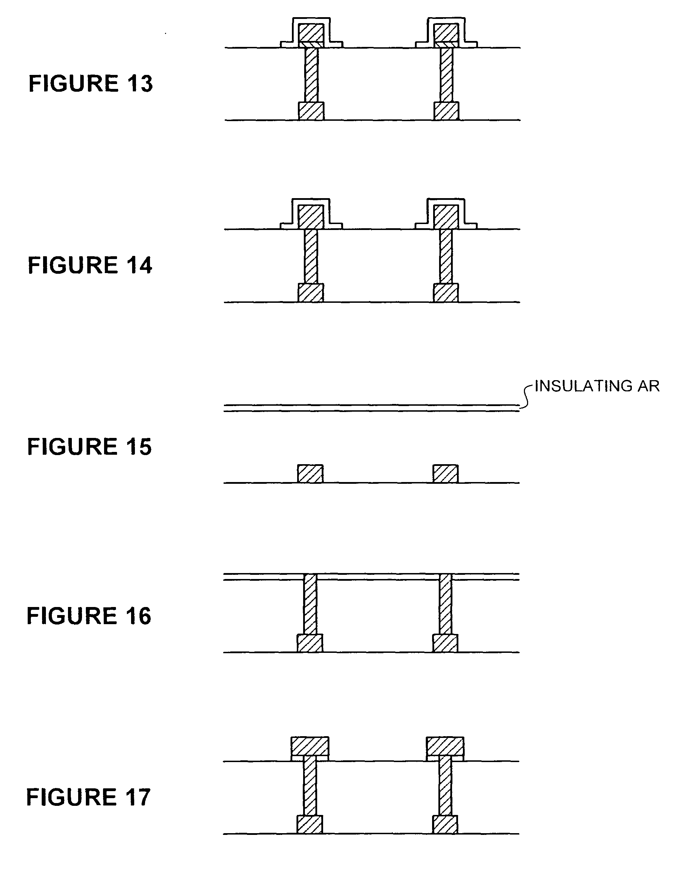

Turning to Figure 12, a pixel array with a top layer of insulating AR coating deposited is shown. After the metal interconnects are formed, a layer of insulating AR coating is deposited using any conventional method, such as the methods named above. The AR coating may then be removed from areas away from the metal interconnects using any conventional method, as shown in Figure 13. As above, those skilled in the art will appreciate that this could be done through any number of methods, including a masking and etching step. In an alternate embodiment, the top layer of insulating AR coating is deposited before the metal interconnects are formed. Then, the bottom layer of AR coating, the metal layer and the top layer of AR coating are patterned and etched in a single step.

Although the manufacture of a pixel array with AR coating on the top and bottom of the metal interconnects is shown, this is not the only way that the invention can be made. In another embodiment, the step where the AR coating is formed on top of the metal interconnect is skipped, in which case a pixel array with AR coating only on the bottom of the metal interconnects is produced, such as shown in Figure 11. Alternatively, the step where the first AR coating is formed may be skipped. In this embodiment, a pixel array with AR coating only on the top of the metal interconnects is produced, as shown in Figure 14.

In an alternate embodiment, an insulating AR coating may be used throughout the manufacturing process. Turning to Figure 15, a pixel array with a layer of insulating AR coating deposited before the vias are formed is shown. After the dielectric is deposited, but before vias are formed, a layer of insulating AR coating is deposited. The coating may be deposited using any of the methods noted above.

Turning to Figure 16, a pixel array with vias formed is shown. After the insulating AR coating is deposited, the vias are formed using any conventional method. As noted above, the particular method chosen to make the vias is not germane to the invention.

Turning to Figure 17, a pixel array with metal interconnects is shown. After the vias are formed, the metal interconnects are formed using a subtractive process similar to the process discussed above. In an embodiment, the metal and the AR coating are removed at the same time, so that the AR coating is found only below the metal interconnects.

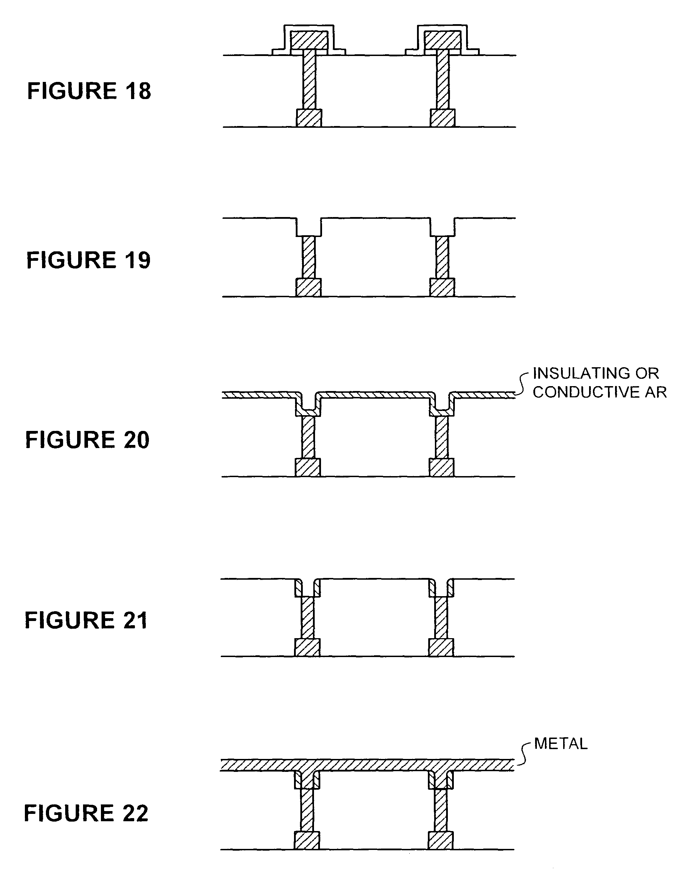

Turning to Figure 18, a pixel array with a top layer of insulating AR coating over the metal interconnects is shown. After the metal interconnects are formed, a top layer of AR coating is formed in the same way as the top layer previously described, through steps of deposition followed by removal. In an embodiment, the lower AR coating is not removed when the interconnect is formed and is then removed when the top layer is removed. In an alternate embodiment, the step where the upper layer of AR coating is formed may be skipped, leaving metal interconnects with the AR coating only on the bottom.

In contrast to the subtractive process generally used for aluminum, an additive process is generally used to form metal interconnects using copper. Embodiments using additive processes will be discussed below. The embodiments described are variations on the damascene process, which is a standard method for forming copper interconnects. In that process, dielectric material is removed in the desired pattern. The surface of the chip is then uniformly covered with the metal for the interconnects. In the final step, the excess metal above the level of the dielectric is removed, usually through chemical-mechanical planarization (CMP). The details of the planarization are known to the art and are not discussed here.

Turning to Figure 19, a pixel array with material removed from the dielectric layer is shown. In this embodiment, after a layer of inter-metal dielectric is deposited and the vias formed, dielectric material is removed in the pattern to be used for the metal interconnects. This may be done using any process known in the art. For example, those skilled in the art will appreciate that this could be done using a mask and etch process. This is known as the initial steps of the damascene process.

Turning to Figure 20, a pixel array with a layer of AR coating deposited is shown. After the dielectric has been removed in the pattern for the metal interconnects, a layer of AR coating is deposited. The AR coating may be either insulating or conductive. The AR coating is deposited conformally, i.e. the thickness of the coating remains the same, regardless of the geometry of the underlying features. The coating may be deposited using any process for conformal deposition, such as CVD or spin coating.

Turning to Figure 21, a pixel array with sidewall spacers is shown. After the AR coating has been deposited, the AR coating is uniformly removed using any conventional method. For example, those skilled in the art will appreciate that any form of dry etching can be used to remove the AR coating. Because the coating is thickest at the edge of vertical steps when it is deposited conformally, the only coating left after etching will be at those steps, forming sidewall spacers of AR material.

Turning to Figure 22, a pixel array with a layer of metal deposited is shown. After the sidewall spacers are formed, a layer of metal is deposited using any method known to the art, such as the methods described above.

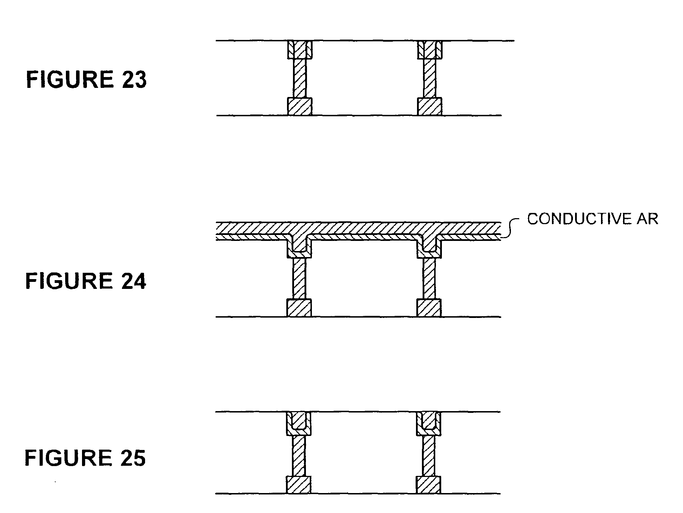

Turning to Figure 23, a pixel array with excess metal removed is shown. After the metal is deposited, the excess metal is removed uniformly down to the level of the dielectric, such as for example using a CMP.

The embodiment just described is not the only way that an additive process can be performed. In another embodiment, the step where the AR coating is etched is skipped. The metal layer is then deposited using any method known in the art, as shown in Figure 24. In this embodiment, a conductive AR coating is used.

Turning to Figure 25, a pixel array with excess metal and AR coating removed is shown. After the metal layer has been deposited, the CMP step described above is performed, leaving a metal interconnect with conductive AR coating on the bottom and sides.

The processes previously discussed describe how to form the metal interconnects at a single level of the semiconductor chip. However, levels of metal interconnects may be added as needed for the workings of the image sensor. The processes discussed can then be repeated for each new layer.

In addition, although metal interconnects with a single layer of AR coating have been shown, the invention is not so limited. In an alternate embodiment, at each stage where a single layer of AR coating was deposited, multiple AR layers may be deposited to form the embodiment shown in Figure 5.

Further, the present description only describes the formation of the AR coating and metal interconnects and does not describe formation of the actual structures within the pixel, which are well known in the art. This is to avoid obscuring the present invention as the steps in forming the active devices within the pixel are well known in the art.

From the foregoing, it will be appreciated that specific embodiments of the invention have been described herein for purposes of illustration, but that various modifications may be made without deviating from the spirit and scope of the invention. Accordingly, the invention is not limited except as by the amended claims.

The following paragraphs describe further aspects and features of the present invention.

1. A CMOS pixel array comprising:

    a plurality of pixels arranged and formed on a semiconductor substrate; and,
    a metal interconnect above the pixels, at least a portion of said metal interconnect coated on at least one side by an anti-reflective coating.

2. The pixel array of paragraph 1 wherein the metal interconnect is coated on all sides by the anti-reflective coating.

3. The pixel array of paragraph 1 wherein the anti-reflective coating is an absorptive coating.

4. The pixel array of paragraph 1 wherein the thickness of the anti-reflective coating is determined by the expected angle of incidence and the expected wavelength of the incident light.

5. The pixel array of paragraph 4 wherein the expected angle of incidence and the expected wavelength of incident light are chosen to reduce reflection from the adjacent pixels.

6. The pixel array of paragraph 4 wherein the expected angle of incidence, e, is determined by the formula $\Theta = \tan^{-1} \dfrac{w}{h}$, where w is the distance from the center of the pixel to the center of the metal interconnect and h is the height of the metal interconnect over the pixel.

7. The pixel array of paragraph 1 wherein the metal interconnect is coated by multiple layers of anti-reflective coating.

8. The pixel array of paragraph 7 wherein the thicknesses of the layers of anti-reflective coating are chosen to reduce reflection of the wavelengths of red, green and blue found in a standard RGB color-coding scheme.

9. The pixel array of paragraph 1 wherein the plurality of pixels are 3T, 4T, 5T, 6T or 7T pixels.

10. The pixel array of paragraph 1 wherein the metal interconnects are found at multiple layers above the pixels.

11. A method for forming a CMOS pixel array, which comprises,
forming the pixels in a semiconductor substrate;
forming a dielectric over the pixels;
forming vias in the positions necessary for a metal interconnect pattern;

forming a bottom layer of conductive anti-reflective coating;

forming a layer of metal over the anti-reflective coating; and

patterning the layer of anti-reflective coating and the layer of metal in the pattern necessary for a metal interconnect pattern.

12. The method of paragraph 11 further including the step of forming a top layer of insulating anti-reflective coating over the layer of metal prior to patterning the metal interconnect pattern.

13. The method of paragraph 11 further including the steps of forming a top layer of insulating anti-reflective coating over the layer of metal and patterning the top anti-reflective coating in the pattern necessary for a metal interconnect pattern.

14. The method of paragraph 11 wherein the steps of forming the layer of dielectric, forming vias, forming the bottom layer of anti-reflective coating, forming the layer of metal and patterning the anti-reflective and the metal are repeated as necessary to form the metal interconnects needed for chip operation.

15. The method of paragraph 11 wherein the metal is aluminium

16. The method of paragraph 11 wherein the conductive anti-reflective coating is tin oxide, indium tin oxide or indium oxide.

17. The method of paragraph 12 wherein the insulating anti-reflective coating is silicon nitride.

18. A method for forming a CMOS pixel array, which comprises,

forming the pixels in a semiconductor substrate;
forming a dielectric over the pixels;
forming a layer of metal over the dielectric layer coating;
forming a top layer of insulating anti-reflective coating; and
patterning the layer of metal and the anti-reflective coating in the pattern necessary for a metal interconnect pattern.

19. The method of paragraph 18 wherein the insulating anti-reflective coating is silicon nitride.

20. A method for forming a CMOS pixel array, which comprises,

forming the pixels in a semiconductor substrate;
forming a dielectric over the pixels;
forming a layer of metal over the dielectric layer;
patterning the layer of metal in the pattern necessary for a metal interconnect pattern.

forming a top layer of conductive anti-reflective coating; and

patterning the anti-reflective coating in the pattern necessary for a metal interconnect pattern.

21. A method for forming a CMOS pixel array, which comprises,

forming the pixels in a semiconductor substrate;
forming a dielectric over the pixels;
forming a bottom layer of insulating anti-reflective coating;
forming vias in the positions necessary for a metal interconnect pattern;
forming a layer of metal over the anti-reflective coating; and
patterning the bottom layer of anti-reflective coating and the layer of metal in the pattern necessary for a metal interconnect pattern.

22. The method of paragraph 21 further including the step of forming a top layer of insulating anti-reflective coating over the layer of metal prior to patterning the metal interconnect pattern.

23. The method of paragraph 21 further including the steps of forming a top layer of insulating anti-reflective coating over the layer of metal and patterning the top anti-reflective coating in the pattern necessary for a metal interconnect pattern.

24. A method for forming a CMOS pixel array, which comprises,

forming the pixels in a semiconductor substrate;
forming a dielectric over the pixels;
forming vias in the positions necessary for a metal interconnect pattern;
removing the dielectric in the pattern necessary for a metal interconnect pattern;
forming a layer of conductive anti-reflective coating over the dielectric layer;
forming a layer of metal over the layer of conductive anti-reflective coating; and
performing a planarization process to remove anti-reflective coating and metal above the plane of the dielectric.

25. The method of paragraph 24 wherein the metal is copper.

26. A method for forming a CMOS pixel array, which comprises,

forming the pixels in a semiconductor substrate;
forming a dielectric over the pixels;
forming vias in the positions necessary for a metal interconnect pattern;
removing the dielectric in the pattern necessary for a metal interconnect pattern;
forming a layer of anti-reflective coating over the dielectric layer;

removing the anti-reflective coating to create sidewall spacers;

forming a layer of metal over the dielectric layer; and

performing a planarization process to remove metal above the plane of the dielectric.

**Claims**

1. A CMOS pixel array comprising:

   a plurality of pixels arranged and formed on a semiconductor substrate; and,
   a metal interconnect above the pixels, at least a portion of said metal interconnect coated on at least one side by an anti-reflective coating.

2. The pixel array of Claim 1 wherein the metal interconnect is coated on all sides by the anti-reflective coating.

3. The pixel array of Claim 1 wherein the anti-reflective coating is an absorptive coating.

4. The pixel array of Claim 1 wherein the thickness of the anti-reflective coating is determined by the expected angle of incidence and the expected wavelength of the incident light.

5. The pixel array of Claim 4 wherein the expected angle of incidence and the expected wavelength of incident light are chosen to reduce reflection from the adjacent pixels.

6. The pixel array of Claim 4 wherein the expected angle of incidence, $\ominus$, is determined by the formula

   $\ominus = \tan^{-1} \dfrac{w}{h}$, where w is the distance from the center of the pixel to the center of the metal interconnect and h is the height of the metal interconnect over the pixel.

7. The pixel array of Claim 1 wherein the metal interconnect is coated by multiple layers of anti-reflective coating.

8. A method for forming a CMOS pixel array, which comprises:

   forming the pixels in a semiconductor substrate;
   forming a dielectric over the pixels;
   forming vias in the positions necessary for a metal interconnect pattern;
   forming a bottom layer of conductive anti-reflective coating;

forming a layer of metal over the anti-reflective coating; and
patterning the layer of anti-reflective coating and the layer of metal in the pattern necessary for a metal interconnect pattern.

9. The method of Claim 8 further including the step of forming a top layer of insulating anti-reflective coating over the layer of metal prior to patterning the metal interconnect pattern.

10. The method of Claim 8 wherein the conductive anti-reflective coating is tin oxide, indium tin oxide or indium oxide.

11. A method for forming a CMOS pixel array, which comprises:

    forming the pixels in a semiconductor substrate;
    forming a dielectric over the pixels;
    forming vias in the positions necessary for a metal interconnect pattern;
    removing the dielectric in the pattern necessary for a metal interconnect pattern;
    forming a layer of conductive anti-reflective coating over the dielectric layer;
    forming a layer of metal over the layer of conductive anti-reflective coating; and
    performing a planarization process to remove anti-reflective coating and metal above the plane of the dielectric.

M21     M22     M2 (METAL 2)

A1    A2    M11    M12    M13    M1 (METAL 1)

TX     TX

FD1     FD2     STI

PD1     PD2

PIXEL 1     PIXEL 2

## FIGURE 1
(PRIOR ART)

AR

M2 (METAL 2)

AR

M1 (METAL 1)

TX     TX

FD1     FD2

PD1     PD2

PIXEL 1     PIXEL 2

## FIGURE 2

$\lambda_1$

$A_1$ $\theta_1$ $A_2$ $B_2$

$B_1$

$t$ ANTI-REFLECTION LAYER

**FIGURE 3**

w

AR

METAL

h $A_1$

$\theta$

$A_2$ TX

PD

**FIGURE 4**

AR1 $\lambda_1$
AR2 $\lambda_2$
AR3 $\lambda_3$

**FIGURE 5**

FD1       FD2       PA

PD1       PD2

# FIGURE 6

D1

TX       TX

PA

# FIGURE 7

**FIGURE 8**

M11⌐ ⌐VIA1
⌐VIA2
⌐M12

**FIGURE 9**

⌐CONDUCTING AR

**FIGURE 10**

⌐METAL

**FIGURE 11**

**FIGURE 12**

⌐INSULATING AR

**FIGURE 13**

**FIGURE 14**

INSULATING AR

**FIGURE 15**

**FIGURE 16**

**FIGURE 17**

**FIGURE 18**

**FIGURE 19**

**FIGURE 20**

INSULATING OR
CONDUCTIVE AR

**FIGURE 21**

**FIGURE 22**

METAL

**FIGURE 23**

**FIGURE 24**

CONDUCTIVE AR

**FIGURE 25**

**European Patent Office**

## EUROPEAN SEARCH REPORT

Application Number

EP 06 25 4309

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2004/135209 A1 (HSIEH TZU-CHIANG [US] ET AL) 15 July 2004 (2004-07-15) * abstract * * paragraphs [0048], [0056], [0057] * ----- | 1-11 | INV. H04N5/217 H04N5/335 H01L27/146 |
| A | US 2003/103150 A1 (CATRYSSE PETER B [US] ET AL) 5 June 2003 (2003-06-05) * abstract * * paragraphs [0008], [0012], [0020], [0023] * ----- | 1-11 | |
| A | US 2004/041224 A1 (CHAO CALVIN [US] ET AL) 4 March 2004 (2004-03-04) * abstract * * paragraphs [0001] - [0011], [0044] - [0046], [0050] - [0052], [0057], [0060] - [0067], [0074], [0083] - [0086], [0090], [0095], [0110], [0117] * * paragraphs [0123], [0124], [0126] * ----- | 1-11 | |
| A | GB 2 408 145 A (MIRADIA INC [US]) 18 May 2005 (2005-05-18) * abstract * * paragraphs [0028], [0032], [0034], [0037], [0040], [0049] - [0051] * ----- -/-- | 1-11 | TECHNICAL FIELDS SEARCHED (IPC) H04N H01L G02B |

The present search report has been drawn up for all claims

| Place of search | Date of completion of the search | Examiner |
|---|---|---|
| Munich | 13 December 2006 | Lauri, Lauro |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 06 25 4309

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WANQING LI ET AL: "Modelling of color cross-talk in CMOS image sensors" 2002 IEEE INTERNATIONAL CONFERENCE ON ACOUSTICS, SPEECH, AND SIGNAL PROCESSING. PROCEEDINGS. (ICASSP). ORLANDO, FL, MAY 13 - 17, 2002, IEEE INTERNATIONAL CONFERENCE ON ACOUSTICS, SPEECH, AND SIGNAL PROCESSING (ICASSP), NEW YORK, NY : IEEE, US, vol. VOL. 4 OF 4, 13 May 2002 (2002-05-13), pages IV-3576, XP010804375 ISBN: 0-7803-7402-9 * the whole document * ----- | 1-11 | |

|  |  |  | **TECHNICAL FIELDS SEARCHED (IPC)** |
|---|---|---|---|

The present search report has been drawn up for all claims

| Place of search | Date of completion of the search | Examiner |
|---|---|---|
| Munich | 13 December 2006 | Lauri, Lauro |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 06 25 4309

This annex lists the patent family members relating to the patent documents cited in the above-mentioned European search report.
The members are as contained in the European Patent Office EDP file on
The European Patent Office is in no way liable for these particulars which are merely given for the purpose of information.

13-12-2006

| Patent document cited in search report | | Publication date | Patent family member(s) | | Publication date |
|---|---|---|---|---|---|
| US 2004135209 | A1 | 15-07-2004 | NONE | | |
| US 2003103150 | A1 | 05-06-2003 | NONE | | |
| US 2004041224 | A1 | 04-03-2004 | NONE | | |
| GB 2408145 | A | 18-05-2005 | CN | 1638115 A | 13-07-2005 |
| | | | DE | 102004051361 A1 | 19-01-2006 |
| | | | JP | 2005167209 A | 23-06-2005 |
| | | | KR | 20050039635 A | 29-04-2005 |
| | | | US | 2005101059 A1 | 12-05-2005 |

EPO FORM P0459

For more details about this annex : see Official Journal of the European Patent Office, No. 12/82